# EUROPEAN PATENT SPECIFICATION

(11) **EP 3 114 530 B1**
(45) Date of publication and mention of the grant of the patent: **28.11.2018**
(21) Application number: 15757780.0
(22) Date of filing: 05.03.2015
(51) Int. Cl.: H01L 51/00, H01L 21/02

(54) **PARTICLE REMOVAL FROM ELECTROCHROMIC FILMS USING NON-AQUEOUS FLUIDS**
PARTIKELENTFERNUNG VON ELEKTROCHROMEN FILMEN UNTER VERWENDUNG NICHTWÄSSRIGER FLÜSSIGKEITEN
ÉLIMINATION DE PARTICULES DE FILMS ÉLECTROCHROMES À L'AIDE DE FLUIDES NON AQUEUX

(30) Priority: 06.03.2014 US 201414198824
(43) Date of publication of application: 11.01.2017
(73) Proprietor: Sage Electrochromics, Inc., Faribault, MN 55021 (US)
(72) Inventor: KALWEIT, Harvey, Burnsville, Minnesota 55021 (US); AJJARAPU, Satya, Apple Valley, Minnesota 55124 (US); GIRON, Jean-Christophe, Edina, Minnesota 55436 (US)
(74) Representative: Zimmermann & Partner Patentanwälte mbB
(86) International application number: PCT/US2015/018980
(87) International publication number: WO 2015/134756

(56) References cited:
- WO-A1-2009/025647
- WO-A2-2007/033008
- WO-A2-2009/148861
- JP-A- 2007 208 246
- KR-A- 20090 042 784
- KR-A- 20130 010 603
- US-A1- 2009 029 274
- US-A1- 2012 145 202

## Description

### BACKGROUND

Large area electronic energy control, display or lighting products that are permanently mounted in structures, such as buildings, ships, aircraft, trains, buses, or cars, may include electronic or electro-optical devices (collectively "electronic energy control devices"), such as electrochromic, organic light emitting diode, electroluminescent, electro-reflective, liquid crystal, and other monolithic display or lighting devices, in which an electronically and optically active media is contained between closely spaced electrodes. The appearance of the lighting or a display created by such electronic energy control devices may be adversely affected by the presence of defects in the active or inactive media that locally modify the potential between the electrodes.

Electronic energy control devices by also be used to modify light transmission over small areas, for example, displays, illuminators, vision systems, sensors, and similar devices. The undesirable effect of a defect is even greater when the size of the device becomes similar to, or even smaller, that the area affected by the defect.

For example, electrochromic devices include electrochromic materials that are known to change their optical properties, in response to application of an electrical potential, so as to make the device, for example, more or less transparent or reflective, or have a desired coloration.

The manufacture of an electrochromic device typically includes forming an electrochromic (EC) film stack including a plurality of layers of conductive and electrochromic material on a substrate, such as glass. See, for example, U.S. Pat. Nos. 5,321,544, 6,856,444, 7,372,610 and 7,593,154. During the manufacturing process, defects sometimes may be formed in one or more of the layers of the EC film that can cause the electrochromic device to have a different optical behavior than desired, or lack a desired optical behavior, at or near the location of the defect when the device is operated by applying an electrical potential thereto. The defect may be an electrical short between conductive layers of the EC film stack caused, for example, by foreign contaminants, or a material non-uniformity or scratch in one or more of layers of the EC film stack, that causes the EC device, when operated, to have at the location of the defect optical properties different than those desired and present at locations adjacent to the defect. The defect, hence, may cause the EC device to have an undesirable aesthetic appearance when operated.

Although various techniques are known and may be performed to repair a defect in an electronic energy control device, such as an electrochromic device, during manufacture, some defects still may remain in a final, manufactured electronic energy control device product. For example, an electrochromic device included in a final, manufactured electrochromic device product, such as an insulated glass unit (IGU), may include defects visible only when the electrochromic device transitions between an energized and non-energized state, and defects not visible in visible or near infrared light. Oftentimes, such defects are noticed or appear only after installation of the electrochromic device product, for example, as an exterior window in a high rise building. It is always more desirable to eliminate the cause of a defect than to try to repair a defect after it has occurred.

It is desirable to reduce the total number of defects or, if possible, completely eliminate all visual or non-visual defects. During the manufacturing of an EC device, or related devices, particulate material or other contaminants may be introduced. For example, the vacuum process for the deposition of the film stack in electrochromic devices may be interrupted at some point in between the deposition of the upper and lower electrical conductors for the purpose of patterning the lower conductor into the proper electrical circuit. After patterning the lower conductor (so that the appropriate electrical connections can be made and voltage applied), EC device processing continues by deposition of the remainder of the film stack. Particles may be generated by the removal, patterning, and other steps between the two deposition steps can have visible defects in the completed EC device, including, as noted above, those defects which may become visible to the operator.
Conventional application of water to remove particulate contaminants may, in some instances, leave water spots, stains, or water flow patterns. Depending on the nature of the substrate or surface being exposed to the water treatment or cleaning, the substrate may bleach, discolor, or become less electrically efficient. In a worst case scenario, water could lead to uniformity differences in coloration of EC devices. Such water-induced defects may only appear during dynamic switching of an electrochromic device, making them difficult to detect, yet sill unappealing to users of the device. WO 2009/148861 A2 is concerned with the use of laser patterning/scribing in electrochromic device manufacture, anywhere during the manufacturing process as deemed appropriate and necessary for electrochromic device manufacturability, yield and functionality, while integrating the laser scribing so as to ensure the active layers of the device are protected to ensure long term reliability. WO 2009/025647 A1 is concerned with azeotropic or azeotrope-like compositions comprising a fluorinated olefin and at least one alcohol, halocarbon, hydrofluorocarbon, fluoroether, or alkanes and combinations thereof, said composition useful in cleaning applications as a degreasing agent or defluxing agent for removing oils and/or other residues from a surface. WO 2007/033008 A2 is concerned with a cleaning composition for cleaning particulate contamination from small dimensions on microelectronic device substrates. The cleaning composition contains dense CO₂ (preferably supercritical CO₂ (SCCO₂)), alcohol, fluoride source, anionic surfactant source, non-ionic surfactant source, and optionally, hydroxyl additive. The cleaning composition enables damage-free, residue-free cleaning of substrates having particulate contamination on Si/SiO₂ substrates..

There remains the need to remove particulate material or other contaminants generated during the manufacturing process without degrading any of the material surfaces or film stacks present in an EC device or other like device (EC device, photochromic device, thermochromic device, liquid crystal display, organic light emitting diode, batteries, or individual thin film materials in other discrete or stand-alone applications).

### SUMMARY

The method according to the present invention is defined in the claims. The method can include preparing a substrate for the receipt of a film or coating material to be deposited in communication with the substrate.

In an embodiment, the method can include preparing a substrate for the receipt of a film or coating material to be deposited in communication with the substrate, where the substrate is at least partially contaminated with particulate matter.

In a further embodiment, the method of preparing a surface of a substrate can include directing a stream of non-aqueous liquid or otherwise exposing the substrate to a non-aqueous liquid, the surface including particulate material; and removing at least a portion of the non-aqueous liquid and at least about 80% of the particulate material from the surface. In a particular embodiment, at least about 90% of the particulate material is removed from the surface.

In another embodiment, the method of preparing an electrochromic device can include: depositing a first conductive layer on a substrate; patterning the first conductive layer; removing particulate material ejected from the pattering from a surface of the first conductive layer, the material removed by directing a stream of non-aqueous fluid towards the surface; depositing one of an electrochromic layer or a counter electrode layer on the first conductive layer to provide a first deposited electrode; depositing an ion-conductor layer on the first deposited electrode; depositing the other of the electrochromic layer or the counter electrode layer on the ion-conductor layer to provide a second deposited electrode; and depositing a second conductive layer on the second deposited electrode.

In a particular embodiment, the non-aqueous liquid includes no greater than about 10% water. In another particular embodiment, the non-aqueous liquid includes no greater than about 5% water. In a further particular embodiment, the non-aqueous liquid includes no greater than about 1% water. In other embodiments, the non-aqueous liquid includes no greater about 0.1% water. In still another embodiment, the non-aqueous liquid includes no greater than about 0.01% water.

In another embodiment, the non-aqueous liquid is non-polar. In a further embodiment, the non-aqueous liquid is polar. In an embodiment, the non-aqueous liquid can have a specified range of values of polar moment. For example, a polar solvent may have a molecular dipole moment of about 1.4 Debye to about 5.0 Debye, with water being about 1.85 Debye. A non-polar solvent may have molecular dipole moments from about 0.0 Debye to about 1.1 Debye. Very strongly non-polar solvents, such as pentane and hexane, have moments very close to 0.0 Debye. Semi-polar solvents occur at all values of dipole strength in between these extremes, and specific values may be desirable in certain instances. All liquids will fit somewhere on this gradient. The non-aqueous liquid includes a fluorocarbon, hydrofluorocarbon, or a non-aqueous surfactant. The particulate material has a size no greater than 1000 microns mm, no greater than about 500 microns, or no greater than about 250 microns, and in a particular embodiment, the particulate matter has a size of at least 1 micron. The particulate material has a size in a range of 0.1 micron to 1000 microns. In a further embodiment, the particulate material has a size in a range of about 1 micron to about 500 µm. In yet another embodiment, the particulate material has a size in a range of about 1 micron to about 250 µm.

In an embodiment, an energy is applied to the non-aqueous liquid to assist in removing the particulate material.

In another embodiment, the electrochromic device has less than about 1 defect per 1 square meter. In yet another embodiment, the substrate is a laminate. In a further embodiment, the electrochromic device is part of an insulated glass unit. In still another embodiment, the insulated glass unit further includes a photovoltaic device. In yet another embodiment, the electrochromic device is heat treated. Lithium is inserted into at least one of the first or second electrodes or the ion conductor layer.

In another aspect, the method of preparing a surface of a substrate can include directing a stream of non-aqueous liquid or exposing the surface being prepared to a non-aqueous liquid, the surface including particulate material having a size in a range of about 1 micron and 1 mm; and removing at least about 98% of the non-aqueous liquid and at least about 90% of the particular material from the surface.

In another embodiment, the surface is a conductive layer of an electrochromic device.

In an embodiment, the conductive surface can consist of a metal, for example, gold, silver, copper, aluminum, nickel, titanium, niobium, tin, indium; or a metal alloy, for example brass or stainless steel.

In another embodiment, the conductive surface can consist of a non-metallic conductor, for example indium tin oxide, aluminum zinc oxide, fluorine-doped tin oxide, and similar materials.

In yet another embodiment, the conductive surface can consist of a form of graphite, such as graphene sheets, nanotubes, fullerene spheres, coated or bonded to a substrate, or forming the substrate itself.

In a further embodiment, the non-aqueous liquid includes less than about 10% water. In a particular embodiment, the non-aqueous liquid includes less than about 5% water. In another embodiment, the non-aqueous liquid includes less than about 1% water. In still another embodiment, the non-aqueous liquid includes less than about 0.1% water. In yet another embodiment, the non-aqueous liquid includes less than about 0.01% water.

In an embodiment, the non-aqueous liquid is non-polar. In another embodiment, the non-aqueous liquid is polar. In a further embodiment, the non-aqueous liquid has a specified range of values of polar moment. A liquid with a molecular dipole moment greater than about 1.4 Debye is considered polar, while one with a molecular dipole moment for less than about 1.1 Debye is considered non-polar. Semi-polar liquids exist with molecular dipole moments between these values. The non-aqueous liquid includes a fluorocarbon, hydrofluorocarbon, or a non-aqueous surfactant. In yet another embodiment, the particulate material has a size in a range of about 1 micron to 1 mm. In another embodiment, the energy is applied to the non-aqueous liquid to assist in removing the particulate material.

### BRIEF DESCRIPTION OF THE DRAWINGS

FIG. 1 illustrates a particular washer concept.
FIG. 2 includes a process flow chart.

### DETAILED DESCRIPTION

The method of the present invention is defined in the claims and can include preparing a substrate or the surface of a substrate for the receipt of a film or coating material to be deposited in communication with the substrate. The method can include preparing a substrate for the receipt of a film or coating material to be deposited in communication with the substrate, where the substrate is at least partially contaminated with particulate matter. In an embodiment, the particulate material includes material removed from the surface of the substrate in a prior process step (e.g., particulate defects). In another embodiment, at least about 90% of a particulate material having a size greater than 2 microns is removed from the surface of the substrate.

The method can include removing particles from a substrate surface, or a surface of a film stack deposited therein, without affecting the appearance of a device including the substrate or film stack. The device is an electrochromic device. The method removes particulate defects with a non-aqueous solution, provided that the non-aqueous solution used does not substantially interact with the substrate or the films deposited on the substrate. Regarding electrochromic devices, their manufacture device can include forming an electrochromic (EC) film stack including a plurality of layers of conductive and electrochromic material on a substrate, such as glass. See, for example, U.S. Pat. Nos. 5,321,544, 6,856,444, 7,372,610 and 7,593,154.

In general, the method includes exposing the surface to be cleaned to a non-aqueous fluid, particularly with the addition of some source of energy to enable such fluid to dislodge particles from the surface. The surface may include any substrate, including those including glass, a polymer, an organic or inorganic thin film (including any film that makes up the various layers of an electrochromic device). A stream of non-aqueous fluid may be directed at a specific angle incident to the surface of the substrate and at a pressure, force, or energy to best effect removal of particular matter. Any stream angle or pressure, force, or energy may be used, provided it does not cause damage to the surface of the substrate or any underlying layers, if any, that are present. Another form of energy may be introduced into the liquid to dislodge particulates, for example ultrasonic vibration, bubble jet impact, laser-induced thermal shock, vapor condensation, and motion of a brush.

In some embodiments the particulate matter is made of a material that is the same as a material of the underlying substrate. Without wishing to be bound by any particular theory, it is believed that any particulate matter left behind could create visible defects in any completed device (e.g., electrochromic device) or could create a short circuit in a device (e.g., a battery or smart window).

The particles to be removed have a size no greater than 1000 microns mm, no greater than about 500 microns, or no greater than about 250 microns, and the size is at least 0.1 micron or at least 1 micron. The particulate material may have a size in a range of 0.1 micron to 1000 microns. In a further embodiment, the particulate material has a size in a range of about 1 micron to about 500 µm. In yet another embodiment, the particulate material has a size in a range of about 1 micron to about 250 µm. In a particular embodiment, about 70% to about 95% of particles having a size in a range of about 2 microns to about 200 microns can be removed.

By way of example, in an embodiment, a conductive layer is deposited on a glass substrate, and material is removed from the conductive layer in a process to pattern a shape into the conductive layer. The material ejected from by patterning process (which is of itself included largely of the material constituting the conductive oxide layer itself) could be left behind on the surface of the conductive layer and is desirable to be removed.

In particular embodiment, the non-aqueous fluid stream is directed toward the surface to be prepared through a bubble jet. A bubble jet uses a high energy jet of liquid from a special nozzle to force particles away from the surface in such a manner that the particles may be flushed away and removed or collected. The bubble jet does this in a manner that does not damage the surface being prepared or any of the underlying layers or film sticks beneath the surface being prepared.

In a further embodiment, the non-aqueous fluid is applied to a surface and then brushes or air streams are used to flush and remove or loosen particulate matter. The non-aqueous fluid may also be applied and energy supplied from ultrasonic transducers to affect mechanical energy transfer to the particulate matter and ultimately flushing or loosening of the material from the substrate or surface to be prepared.

The person of ordinary skill in the art would be able to envision other means through which mechanical energy may be applied, in conjunction with the non-aqueous fluid, to affect a flushing or loosening of particulate matter from the substrate or surface to be prepared by transferring the applied mechanical or kinetic energy to the particulate matter.

Fluids having low surface energies, for example, 3M Novec 7300™-brand fluid, are used to advantage because this property assists in keeping particles removed from a surface in suspension. Proper surfactants added to a higher surface energy non-interacting non-aqueous fluid may be used to advantage for the same purpose.

The non-aqueous fluid is a fluid that does not interact with the substrate or surface being prepared or any layer in communication with the surface being prepared. In an embodiment, the non-aqueous liquid is a non-polar organic liquid. In another embodiment, the non-aqueous liquid is a polar organic liquid. In other embodiments, the non-aqueous liquid is an organic liquid having a polar moment with a specified range. In still another embodiment, the non-aqueous liquid is a polar protic solvent. In yet another embodiment, the non-aqueous liquid is a polar aprotic solvent.

The non-aqueous fluid may include a small amount of water. The non-aqueous liquid can include less than about 10% water. In a particular embodiment, the non-aqueous liquid includes less than about 5% water. In another embodiment, the non-aqueous liquid includes less than about 1% water. Water content less than 1% water may be particularly advantageous to reduce the likelihood of significantly affecting the device being manufactured. In still another embodiment, the non-aqueous liquid includes less than about 0.1% water. In a particular example, the non-aqueous solution is a mixture of the non-aqueous organic liquid and water, where the solution may contain up to .01% water, provide that the non-aqueous organic liquid and water are miscible. If the non-aqueous liquid contains water, the water is preferred to be deionized water or distilled water.

The non-aqueous liquid can be non-flammable. In another embodiment, the non-aqueous liquid can be relatively non-toxic. In a further embodiment, the non-aqueous liquid can be recyclable (e.g., where the particulate matter could be removed from the liquid, and the liquid reused in subsequent processing). In yet another embodiment, the non-aqueous liquid is an oil with a high flash point, such as those commonly used to store lithium.

The non-aqueous liquid may be selected based on the material of the particulate matter, such that chemical or physical interactions may exist between the particulate matter and the liquid to assist in the removal of the particulate matter from the surface being prepared. For example, van der Waals forces or hydrogen bonds may temporarily exist between the liquid and the particulate matter aiding in the flushing or loosening of the matter from the surface being prepared (and, in some examples, this would allow lowering of the mechanical energy supplied to the surface or liquid stream). One skilled in the art will be able to select an appropriate liquid and mechanical energy supplied to best flush or loosen a material from the substrate or surface and to prevent damage to the surface or layer in communication with the surface.

In an embodiment, the non-aqueous liquid is a hydrofluorocarbon liquid. In a further embodiment, the non-aqueous liquid includes a fluorocarbon. In a particular embodiment, the non-aqueous liquid is a polymeric fluorinated solvent. In yet a further embodiment, the non-aqueous liquid includes a surfactant. In yet another embodiment, the non-aqueous liquid includes a non-interacting fluid with the addition of a different surfactant.

A non-aqueous liquid may have at least one of the following properties: (1) only minimally interacts with the surface being prepared; (2) leave minimal stains or deposits; (3) is readily removable; (4) is relatively non-toxic or non-carcinogenic; (5) has low interaction with the environment (e.g., ozone depletion, greenhouse effect); (6) is non-flammable or has low flammability; (7) is relatively non-corrosive; (8) is cost effective; and (9) provides little interaction with upstream or downstream processes (e.g., common washer construction materials).

A family of suitable hydrofluorocarbon liquids is available from 3M under the trade name Novec™. Four examples of 3M Novec™-brand liquids include 7300, 7200, 7100, and 71IPA. The inventors have found that 71IPA was found to increase film marks similar to those marks left behind from water. However, the inventors have observed that no marks were left from the other liquids in this group. In addition, the inventors have found these liquids to have a suitable low toxicity and are non-flammable, or weakly flammable, making integration into the industrial environment safer than many hydrocarbon based liquids. Moreover, the inventors have found that the fluorocarbon based liquids mark less, cause less bleaching to the surface material to which it is applied, or alter the color or optical density of the surface or dynamic switching rate of any film layers in communication thereof.

In other embodiments, the non-aqueous liquid includes 3M Novec™-brand 4200, 3M FC-4434, 3M Novec™-brand 4300, 3M FC-4432, 3M Novec™-brand fluid HFE-7000, 3M Novec™-brand fluid HFE-7100, 3M Novec™-brand fluid HFE-7200, 3M Novec™-brand fluid HFE-7500,3M Novec™-brand fluid HFE-71IPA, 3M Fluorinert™-brand FC-72, 3M Fluorinert™-brand FC-84, 3M Fluorinert™-brand FC-77, 3M Fluorinert™-brand FC-3255, 3M Fluorinert™-brand FC-3283, 3M Fluorinert™-brand FC-40, 3M Fluorinert™-brand FC-43, 3M Fluorinert™-brand FC-70, 3M FC-4430, or any mixture thereof. In an exemplary embodiment, the non-aqueous liquid includes 3M Novec™-brand 4200, 3M FC-4434, 3M Novec™-brand 4300, 3M FC-4432, 3M Novec™-brand fluid HFE-7000, 3M Novec™-brand fluid HFE-7100, 3M Novec™-brand fluid HFE-7200, 3M Novec™-brand fluid HFE-7500, , 3M Fluorinert™-brand FC-72, 3M Fluorinert™-brand FC-84, 3M Fluorinert™-brand FC-77, 3M Fluorinert™-brand FC-3255, 3M Fluorinert™-brand FC-3283, 3M Fluorinert™-brand FC-40, 3M Fluorinert™-brand FC-43, 3M Fluorinert™-brand FC-70, 3M FC-4430, or any mixture thereof. In an embodiment, the liquid can have a fluoride concentration, by weight, based on active content, no greater than about 50,000 ppm or no greater than about 5000 ppm, and in another embodiment, a fluoride concentration, by weight, based on active content, or at least 1 ppm or at least 100 ppm. In a particular embodiment, such liquid has a fluoride concentration, by weight, based on active content, in a range of about 1 ppm to about 50,000 ppm or about 100 ppm to about 5000 ppm.

Another non-aqueous liquid can include a fluoride surfactant that may be or contain a composition according to the formula: Rf-SO₃⁻M⁺, where the Rf is a C1 to C12 perfluoroalkyl group, and M⁺ is a cation, a H⁺ atom or an ammonia group. In an embodiment, the fluoride surfactant may be or contain a composition according to the formula: Rf-SO₂N⁻-R¹M⁺, where the Rf is a C1 to C12 perfluoroalkyl group; R¹ is H, an alkyl group, a hydroxyalkyl group, an alkylamine oxide group, an alkylcarboxylate group or aminoalkyl group; and M⁺ is a cation, a H⁺ atom or an ammonia group. The alkyl, hydroxylalkyl, alkylamine oxide, alkylcarboxylate or aminoalkyl groups of R¹ groups may have from 1 to 6 carbon atoms. The hydroxylalkyl group may have the formula - (CH₂)x-OH, where x is an integer from 1 to 6.

Another non-aqueous liquid can include a fluoride surfactant may be or contain a composition according to the formula: Rf-Q-R¹SO₃⁻M⁺, where the Rf is a C1 to C12 perfluoroalkyl group; R¹ is alkylene of the formula - CₙH₂ₙ(CHOH)ₓCₘH₂ₘ-, the n and m are independently 1 to 6 and x is 0 to 1, and is optionally substituted by a catenary oxygen or nitrogen group; M⁺ is a cation; Q is -O- or -SO₂NR²-; and the R²- is an H-, alkyl, aryl, hydroxyalkyl, aminoalkyl, or sulfonatoalkyl group, optionally containing one or more catenary oxygen or nitrogen heteroatoms. The alkyl, aryl, hydroxyalkyl, aminoalkyl, or sulfonatoalkyl group may have from 1 to 6 carbon atoms. The hydroxyalkyl group may be of the formula -C_{P}H₂ₚ-OH, where the p is an integer from 1 to 6. The aminoalkyl group may be of the formula -CₚH₂ₚ-NR³R⁴, where the p is an integer of 1 to 6 and R³ and R⁴ are independently H or alkyl groups of 1 to 6 carbon atoms. The R¹ group is -CₙH₂ₙCH(OH)CₘH₂ₘ-, and the n and m are independently 1 to 6.

In an embodiment, the non-aqueous liquid is recovered or recycled. For example, the solvent may be filtered to remove particles above a certain size by methods such as vacuum or atmospheric distillation, sub-micro filtration, or sorption filtration.

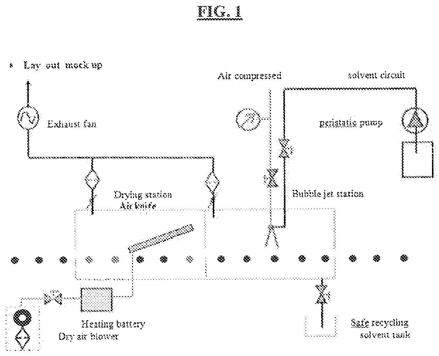

A flat glass washer using bubble jet energy and 3M Novec 7300 has been designed and constructed to demonstrate the effectiveness of this method of particle removal, without damage the electrochromic films. A drawing of this system is found in FIG. 1.

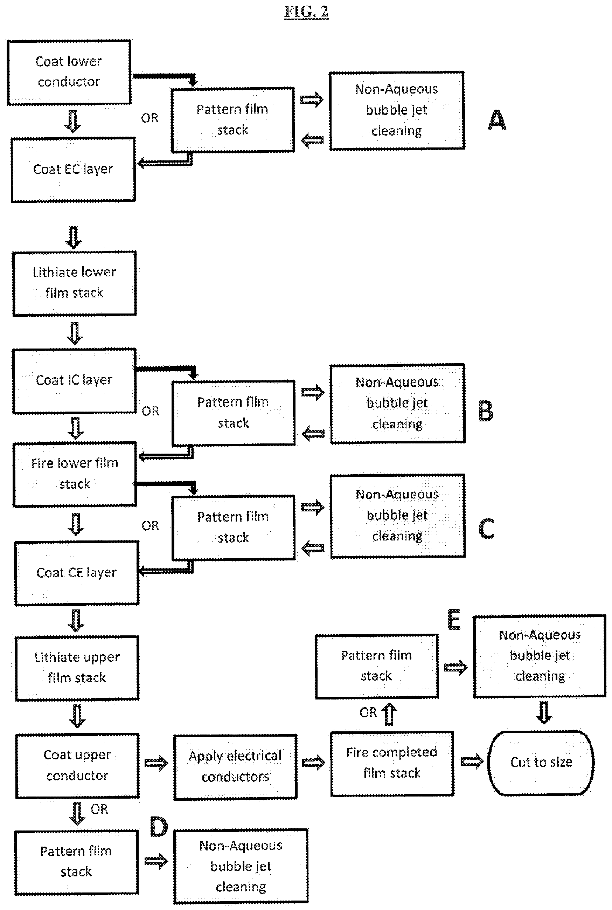

Process flow diagram showing alternate locations for patterning and non-aqueous cleaning of particulate debris. The cleaning step can be inserted wherever particulate removal helps yield and quality. The cleaning step is helpful when if follows a patterning step, and particularly, at the patterning/cleaning sequence B as illustrated in FIG. 2.

Many different aspects and embodiments are possible. Some of those aspects and embodiments are described herein. After reading this specification, skilled artisans will appreciate that those aspects and embodiments are only illustrative. Embodiments may be in accordance with any one or more of the items as listed below.

Tests were performed to determine how fluids performed when exposed to a surface of an electrochromic (EC) layer. In one test (Test 1) of non-aqueous liquid exposure, a device substrate was paused on a horizontal conveyor after an EC layer had been deposited. Several non-aqueous liquids were applied to the surface of the EC layer, in quantities of approximately 1 cm³, and allowed to pool on the surface for about 10 seconds. These liquids were applied in locations that were carefully measured and recorded, to allow subsequent observation of the exact locations treated. After about 10 seconds of elapsed time, an air jet was used to blow the pool of liquid across the device. At this point, no marks associated with the liquids were visible on the surface. This substrate was then further processed. After processing, this device (an electrochromic device) was colored and bleached according to standard test protocols, and the measured locations at which the test liquids had been applied were carefully monitored.

Five liquids were used in this experiment: deionized water (control); 3M Novec™-brand 7300 fluid; 3M Novec™-brand 7200 fluid; 3M Novec™-brand 7100 fluid; and 3M Novec™-brand 71IPA fluid. In Test 1, water was tested as a control to ensure that this particular film stack did exhibit its characteristic sensitivity to water, and so assured us that were dealing with a film stack that behaved in the expected manner. Test 2 was a repeat of Test 1, except that water was not used as the control. In Test 2, a larger area of the device to be exposed to each of the four 3M Novec non-aqueous solvents, as the water was not tested during Test 2. The results are shown in the following Table A:

| Liquid: | Test 1 | Test 2 |
|---|---|---|
| DI water | very strongly marked | not used |
| Novec 71IPA | strongly marked | strongly marked |
| Novec 7100 | no visible marks | no visible marks |
| Novec 7200 | no visible marks | no visible marks |
| Novec 7300 | no visible marks | no visible marks |

The water left mottled light areas with dark edges around the original pool location, and dark-edged light streaks in areas over which the liquid had been blown by the applied air jets. These defects showed up at various points in the coloring and bleaching cycles, as well as in the final fully colored state, and were characterized by differences in switching rate, as well as ultimate optical density. Novec™-brand 71IPA fluid, which is a combination of Novec™-brand 7100 fluid and isopropanol (IPA), showed behavior very similar to that of water, but a little less strongly marked. The other Novec™-brand fluorinated solvents, left no marks at all visible in the electrochromic device during coloring or bleaching. Novec™-brand 7100 fluid, Novec™-brand 7200 fluid, and Novec™-brand 7300 fluid showed no visible marking of the electrochromic devices at all, while bleaching, coloring, or in transition. The lack of a transitional defect is important, since slower switching speed can be the first indication of an interaction between a cleaning fluid and an electrochromic device.

Note that not all of the activities described above in the general description or the examples are required, that a portion of a specific activity may not be required, and that one or more further activities may be performed in addition to those described. Still further, the order in which activities are listed is not necessarily the order in which they are performed.

Benefits, other advantages, and solutions to problems have been described above with regard to specific embodiments. However, the benefits, advantages, solutions to problems, and any feature(s) that may cause any benefit, advantage, or solution to occur or become more pronounced are not to be construed as a critical, required, or essential feature of any or all the claims.

The specification and illustrations of the embodiments described herein are intended to provide a general understanding of the structure of the various embodiments. The specification and illustrations are not intended to serve as an exhaustive and comprehensive description of all of the elements and features of apparatus and systems that use the structures or methods described herein. Separate embodiments may also be provided in combination in a single embodiment, and conversely, various features that are, for brevity, described in the context of a single embodiment, may also be provided separately or in any subcombination. Further, reference to values stated in ranges includes each and every value within that range. Many other embodiments may be apparent to skilled artisans only after reading this specification. Other embodiments may be used and derived from the disclosure, such that a structural substitution, logical substitution, or another change may be made without departing from the scope of the disclosure. Accordingly, the disclosure is to be regarded as illustrative rather than restrictive.

## Claims

1. A method of removing particulate material or other contaminants generated during the manufacturing process from a surface of a substrate, the method comprising exposing the surface to a non-aqueous liquid, wherein the surface is a first electrode, a second electrode and/or an ion conductor layer of an electrochromic device and has lithium inserted into it, wherein the non-aqueous liquid is a fluorocarbon, hydrofluorocarbon, or a non-aqueous surfactant, and wherein the particulate material has a size in a range of 0.1 micron to 1000 microns.

2. The method of claim 1, further comprising patterning a layer of the substrate, wherein the particulate material is generated during patterning, and exposing the surface is performed after patterning the layer.

3. The method of claim 1, wherein the non-aqueous liquid includes a fluorocarbon having a perfluoroalkyl group having 1 to 12 carbon atoms.

4. The method of claim 1, wherein the non-aqueous liquid has a fluoride concentration, by weight, based on active content, in a range of 1 ppm to 50,000 ppm.

5. The method of any one of the preceding claims, wherein the surface comprises a silicate glass, a non-silicate glass, a crystal, an amorphous semiconductor, a polymer, a copolymer, a liquid crystal polymer, a film of inorganic material, a film of organic material, or a composite of organic material and inorganic material.

6. The method of any one of the preceding claims, wherein the non-aqueous liquid is delivered to the surface in the form of a stream or jet of sufficient velocity to dislodge particles from the surface on which it impinges.

7. The method of any one of the preceding claims, wherein the non-aqueous liquid has a polarity in a range of 0.0 Debye to 1.1 Debye.

8. The method of any one of claims 1 to 6, wherein the non-aqueous liquid has a polarity in a range of 1.4 Debye to 5.0 Debye.

9. The method of any one of the preceding claims, wherein the particulate material has a size in a range of 1 micron to 500 microns, or 2 microns to 250 microns.

10. The method of any one of the preceding claims, wherein an energy is applied, the energy is ultrasonic agitation of the liquid, bubble jet agitation, thermal heating of the liquid, or any combination thereof.

## Patentansprüche

1. Verfahren zum Entfernen von teilchenförmigem Material oder anderen Verunreinigungen, die während des Herstellungsprozesses erzeugt werden, von einer Oberfläche eines Substrats, wobei das Verfahren das Aussetzen der Oberfläche einer nichtwässrigen Flüssigkeit umfasst, wobei die Oberfläche eine erste Elektrode, eine zweite Elektrode und/oder eine lonenleiterschicht einer elektrochromen Vorrichtung ist und Lithium in sie eingesetzt ist, wobei die nichtwässrige Flüssigkeit ein Fluorkohlenstoff, Fluorkohlenwasserstoff oder ein nichtwässriges Tensid ist, und wobei das teilchenförmige Material eine Größe in einem Bereich von 0,1 µm bis 1000 µm aufweist.

2. Verfahren nach Anspruch 1, ferner umfassend das Pattern einer Schicht des Substrats, wobei das teilchenförmige Material während des Patterns erzeugt wird, und das Freilegen der Oberfläche nach dem Pattern der Schicht durchgeführt wird.

3. Verfahren nach Anspruch 1, wobei die nichtwässrige Flüssigkeit einen Fluorkohlenwasserstoff mit einer Perfluoralkylgruppe mit 1 bis 12 Kohlenstoffatomen beinhaltet.

4. Verfahren nach Anspruch 1, wobei die nichtwässrige Flüssigkeit eine Fluoridkonzentration, bezogen auf den aktiven Gehalt, in einem Bereich von 1 ppm bis 50.000 ppm aufweist.

5. Verfahren nach einem der vorstehenden Ansprüche, wobei die Oberfläche ein Silikatglas, ein Nicht-Silikatglas, einen Kristall, einen amorphen Halbleiter, ein Polymer, ein Copolymer, ein Flüssigkristallpolymer, einen anorganischen Materialfilm, einen organischen Materialfilm oder einen Verbund aus organischem Material und anorganischem Material umfasst.

6. Verfahren nach einem der vorhergehenden Ansprüche, wobei die nichtwässrige Flüssigkeit in Form eines Stroms oder Strahls mit ausreichender Geschwindigkeit an die Oberfläche abgegeben wird, um Partikel von der Oberfläche zu entfernen, auf die sie trifft.

7. Verfahren nach einem der vorhergehenden Ansprüche, wobei die nichtwässrige Flüssigkeit eine Polarität in einem Bereich von 0,0 Debye bis 1,1 Debye aufweist.

8. Verfahren nach einem der Ansprüche 1 bis 6, wobei die nichtwässrige Flüssigkeit eine Polarität in einem Bereich von 1,4 Debye bis 5,0 Debye aufweist.

9. Verfahren nach einem der vorstehenden Ansprüche, wobei das teilchenförmige Material eine Größe in einem Bereich von 1 µm bis 500 µm oder 2 µm bis 250 µm aufweist.

10. Verfahren nach einem der vorstehenden Ansprüche, wobei eine Energie aufgebracht wird, wobei die Energie eine Ultraschallbewegung der Flüssigkeit, eine Blasenstrahlbewegung, eine thermische Erwärmung der Flüssigkeit oder eine Kombination davon ist.

## Revendications

1. Procédé d'élimination de matière particulaire ou d'autres contaminants produits pendant le procédé de fabrication à partir d'une surface d'un substrat, le procédé comprenant l'exposition de la surface à un liquide non aqueux, dans lequel la surface est une première électrode, une seconde électrode et/ou une couche conductrice d'ions d'un dispositif électrochrome et du lithium étant inséré à l'intérieur, le liquide non aqueux étant un fluorocarbone, un hydrofluorocarbone ou un tensioactif non aqueux, et la matière particulaire ayant une taille dans une plage comprise entre 0,1 micron et 1 000 microns.

2. Procédé selon la revendication 1, comprenant en outre la structuration d'une couche du substrat, la matière particulaire étant produite pendant la structuration, et l'exposition de la surface étant réalisée après la structuration de la couche.

3. Procédé selon la revendication 1, dans lequel le liquide non aqueux comprend un fluorocarbone ayant un groupe perfluoroalkyle comportant de 1 à 12 atomes de carbone.

4. Procédé selon la revendication 1, dans lequel le liquide non aqueux a une concentration en fluorure, en poids, en fonction du contenu actif, dans une plage comprise entre 1 ppm et 50 000 ppm.

5. Procédé selon l'une quelconque des revendications précédentes, dans lequel la surface comprend un verre de silice, un verre sans silice, un cristal, un semi-conducteur amorphe, un polymère, un copolymère, un polymère à cristaux liquides, un film de matériau inorganique, un film de matériau organique ou un composite de matériau organique et de matériau inorganique.

6. Procédé selon l'une quelconque des revendications précédentes, dans lequel le liquide non aqueux arrive en surface sous la forme d'un courant ou d'un jet de vitesse suffisante pour déloger des particules de la surface qu'il impacte.

7. Procédé selon l'une quelconque des revendications précédentes, dans lequel le liquide non aqueux présente une polarité dans une plage comprise entre 0,0 debye et 1,1 debye.

8. Procédé selon l'une quelconque des revendications 1 à 6, dans lequel le liquide non aqueux présente une polarité dans une plage comprise entre 1,4 debye et 5,0 debye.

9. Procédé selon l'une quelconque des revendications précédentes, dans lequel la matière particulaire a une taille dans une gamme comprise entre 1 micron et 500 microns, ou entre 2 microns et 250 microns.

10. Procédé selon l'une quelconque des revendications précédentes, dans lequel une énergie est appliquée, l'énergie étant une agitation ultrasonique du liquide, une agitation par jet à bulle, un chauffage thermique du liquide ou leurs combinaisons.
